(19) Europäisches Patentamt

European Patent Office

Office européen des brevets

(11) **EP 1 091 487 B1**

(12) **EUROPEAN PATENT SPECIFICATION**

(45) Date of publication and mention
of the grant of the patent:
**11.12.2002 Bulletin 2002/50**

(51) Int Cl.⁷: **H03J 5/02**

(21) Application number: **99120134.4**

(22) Date of filing: **08.10.1999**

(54) **Method and apparatus for eliminating self quieter signals generated in synthesiser receivers**

Methode und Vorrichtung zur Unterdrückung von zur Selbst-Stummschaltung führenden Signalen in Synthesizer-Empfängern

Procédé et dispositif pour supprimer des signaux causant l'auto-évanouissement dans des récepteurs synthétiseurs

(84) Designated Contracting States:
**DE FR GB**

(43) Date of publication of application:
**11.04.2001 Bulletin 2001/15**

(73) Proprietor: **MOTOROLA, INC.**
**Schaumburg, IL 60196 (US)**

(72) Inventors:
• **Erler, Wolfgang**
**65232 Taunusstein (DE)**

• **Gregory, Ralf**
**64295 Darmstadt (DE)**

(74) Representative: **Richardt, Markus Albert**
**Motorola GmbH,**
**Intellectual Property Dept.,**
**Hagenauerstrasse 47**
**65203 Wiesbaden (DE)**

(56) References cited:
**EP-A- 0 803 997          GB-A- 2 250 877**
**US-A- 4 545 072          US-A- 4 551 856**
**US-A- 4 969 210**

## Description

### FIELD OF THE INVENTION

The present invention is generally related to radio frequency (RF) signal receivers, and more particularly to an improved method and apparatus for eliminating interference caused by harmonic waves of frequency signals generated by an oscillator of the radio frequency signal receiver.

### BACKGROUND OF THE INVENTION

Conventional radio frequency signal receivers, such as a receiver for the frequency range of about 130 MHz to 180 MHz, comprise one or more oscillators, such as a reference or clock oscillator generating an oscillator frequency with 16.8 MHz, which is divided by a divider by the divisor 8, i.e. a divided oscillator frequency of 2.1 MHz. US-A-4 969 210 shows a general example for such a receiver.

If the radio frequency signal receiver is tuned to receive an RF signal from a signal source with a frequency, which is an integral multiple of the oscillator frequency, such as 168 MHz, or of the divided oscillator frequency, a harmonic wave of the oscillator frequency (10 *16.8 MHz = 168 MHz) or of the divided oscillator frequency (80 *2.1 MHz = 168 MHz) may cause interference with the received signal and thus may disturb the demodulation of the transmitted signal on the received carrier wave onto which the transmitted signal is modulated. This is of particular importance, if the received signal comprises a low signal level with regard to the signal level of the matching harmonic wave, i.e. a low signal to noise ratio.

Accordingly, in conventional radio frequency signal receivers it is not appropriate (to allow) to adjust or tune the receiver to demodulate an incoming signal with a frequency value, which is an integral multiple of such oscillator frequency of one or more oscillators within the receiver.

Such oscillator frequencies, which are an integral multiple of the adjusted or tuned incoming frequency to be demodulated are called "self quieters", since they tend to make the receiver to appear quiet, although no signal is received.

This problem is also adressed e.g. in EP-A-0 803 997 or GB-A-2 250 877.

### SUMMARY OF THE INVENTION

Accordingly, it is an object of the present invention to provide a method and an apparatus for dynamically eliminating interference due to self quieters generated in receivers.

It is another object of the present invention to provide a method and an apparatus, which allows a receiver to be adjusted or tuned to receive any frequency within the frequency range for which the receiver is suitable to demodulate modulated radio waves.

It is yet another object of the present invention to provide a method and an apparatus, wherein the oscillator frequency causing self quieters may be shifted.

It is yet a further object of the present invention to provide a method and an apparatus, wherein the frequency shift of the oscillator frequency causing one or more self quieters is compensated by compensating means.

Briefly described, the present invention encompasses a radio frequency (RF) signal receiver that includes an oscillator generating a signal with an oscillator frequency, which may cause a self quieter and a synthesiser being adjusted by first and second dividers. The first divider divides the oscillator frequency by a first divisor and the second divider divides the output frequency of a voltage controlled oscillator VCO by a second divisor, which both are independently setable by divider setting means. If a harmonic of the "normal" oscillator frequency is a self quieter, the "normal" oscillator frequency is shifted, such as about 25 kHz for a receiver with a frequency range from 130 to 180 MHz. In order to obtain the same output frequency at the voltage controlled oscillator VCO, when shifting the "normal" oscillator frequency to the shifted oscillator frequency (which is not an integral multiple of the incoming frequency adjusted or tuned at the receiver for demodulation), at least one of the divisors is incremented or decremented, preferably by the number 1. Thereby, the frequency shift of the output frequency of the VCO resulting from the frequency shift of the oscillator frequency causing the self quieter is compensated.

### BRIEF DESCRIPTION OF THE DRAWINGS

In the drawings, the same reference sign have been used for the same parts or parts with a similar effect.

Fig. 1 represents a known synthesiser arrangement for the generation of an intermediate frequency of a radio frequency receiver;

Fig. 2 depicts a synthesiser arrangement according to the invention for eliminating self quieters;

Fig. 3 shows a process flow diagram explaining the function of the synthesiser arrangement of Fig. 2.

The known as well as the inventive synthesiser arrangement may be used to generate an intermediate frequency $F_i$ in radio frequency receivers, which are suitable to demodulate transmitted signals being modulated onto a carrier wave with a frequency in the range of about 130 - 180 MHz. However, this is only a non-limiting example of a frequency range and receiver. In fact, the inventive synthesiser arrangement can be used in a synthesiser receiver of any frequency range.

PRIOR ART:

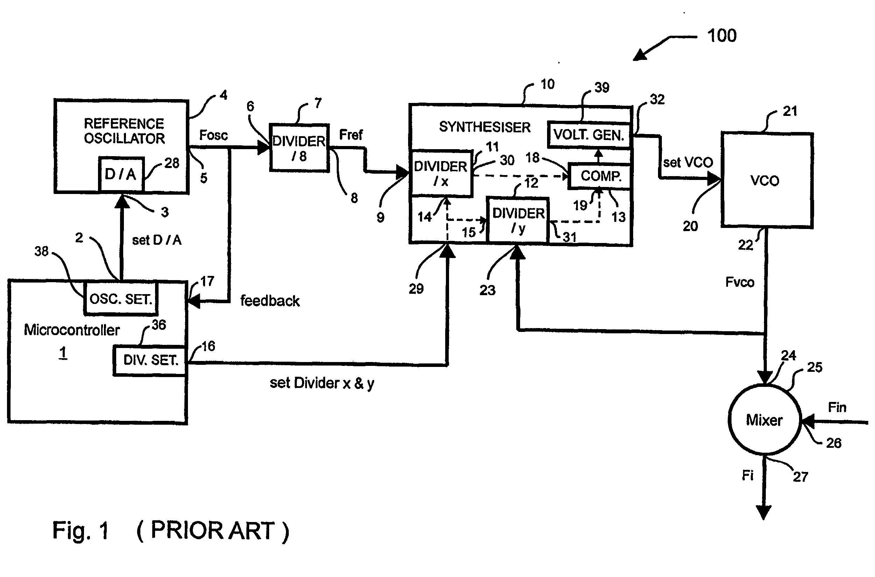

Synthesiser arrangement 100, depicted in Fig. 1, comprises a known microcontroller 1, reference oscillator 4, divider 7, synthesiser 10, voltage controlled oscillator (VCO) 21 and mixer 25. The known synthesiser 10 comprises a divider 11, a divider 15 and a comparator 13 and the known reference oscillator 4 comprises a digital/analog converter (D/A) 28.

The microcontroller 1 comprises oscillator setting means 38 generating a digital value, which is applied to the digital/analog converter 28 of the reference oscillator 4. Depending on the digital value, which is applied to input 3 of the digital/analog converter 28, the digital/analog converter 28 generates a voltage to drive the reference oscillator.

By those skilled in the art it is known that the range of possible adjustment of the known reference oscillator is small, typically in the range of up to 100 kHz.

Just for better understanding, without limiting the inventive concept, which will be described in detail, it is assumed that the user of the receiver adjusted an incoming frequency, i.e. a receiver frequency, of 168 MHz. In this case, the reference oscillator 4 generates an oscillator frequency of 16.8 MHz in the known arrangement shown in Fig. 1 and the oscillator frequency of reference oscillator 4 is applied to its output 5. The oscillator frequency at output 5 is fed back to the microcontroller 1, which checks, whether the oscillator frequency is appropriate for the radio frequency receiver (not shown) to demodulate a signal on a carrier frequency, which has been adjusted at the receiver, such as by the user of the receiver. In addition to applying the oscillator frequency of the reference oscillator 4 on output 5 to input 17 of the microcontroller 1, the oscillator frequency of the reference oscillator 4 is also applied to input 6 of the divider 7, which divides the oscillator frequency of the reference oscillator 4 by a divisor, which is the number 8.

Accordingly, the divider 7 generates a reference frequency $F_{ref}$ of 2.1 MHz at its output 8, which is applied to input 9 of the divider 11 of the synthesiser 10. The divider 11 divides the reference frequency by a divisor x, which is the number 84 in this example, and the divisor or number is set by an appropriate signal on output 16 at microcontroller 1, which is applied to input 29 of the synthesiser 10. In addition, the microcontroller 1 generates a signal at its output 16, which is applied to divider 12 of the synthesiser 10 to set a divisor by which divider 12 of synthesiser 10 divides the output frequency $F_{VCO}$ of the voltage controlled oscillator 21 at its output 22 and input 23 of the synthesiser 10.

In this example, the divisor by which the reference frequency $F_{ref}$ is divided by divider 12 is the number 8514. At its output 30, the divider 11 generates a frequency, which is the reference frequency $F_{ref}$ divided by the divisor x, which is applied to input 18 of comparator 13. Divider 12 generates at its output 31 a frequency, which is the output frequency $F_{VCO}$, divided by the number y - as mentioned the number 8514 in this example. The output frequency $F_{VCO}$ of VCO 21 divided by divider 12 and generated at its output 31 is applied to input 19 of comparator 13.

Depending on the ratio of the divisor x and the divisor y, both set by the microcontroller 1, the comparator 13 triggers a voltage generator 39 to generate a voltage at the output 32 of the synthesiser 10 corresponding to said ratio. The voltage generated by voltage generator 39 is applied to an input 20 of the voltage controlled oscillator 21, which generates an output frequency $F_{VCO}$ in known manner. The output frequency generated by voltage controlled oscillator 21 is applied to its output 22, which is electrically connected with input 23 of synthesiser 10 and input 24 of mixer 25.

In this example, the output frequency $F_{VCO}$ generated by voltage controlled oscillator 21 and controlled by synthesiser 10 is 212.85 MHz. Voltage controlled oscillator 21 is also known as a local oscillator by those skilled in the art.

At input 26 of mixer 25 the incoming frequency $F_{in}$, which is a carrier wave, whose frequency is modulated (frequency modulation (FM)) or whose amplitude is modulated (amplitude modulation (AM)) by a signal to be demodulated by the receiver, such as to be listened to via loudspeakers (not shown) of the receiver, is applied. The signal applied to input 26 of mixer 25 is mixed in known manner with the output frequency $F_{VCO}$ generated by voltage controlled oscillator 21 and applied to input 24 of the mixer. The resulting intermediate frequency $F_i$ generated by mixer 25 is applied in known manner to known electronic circuits (not shown) of the receiver to output the received modulation of the received carrier wave.

PREFERRED EMBODIMENT OF THE INVENTION:

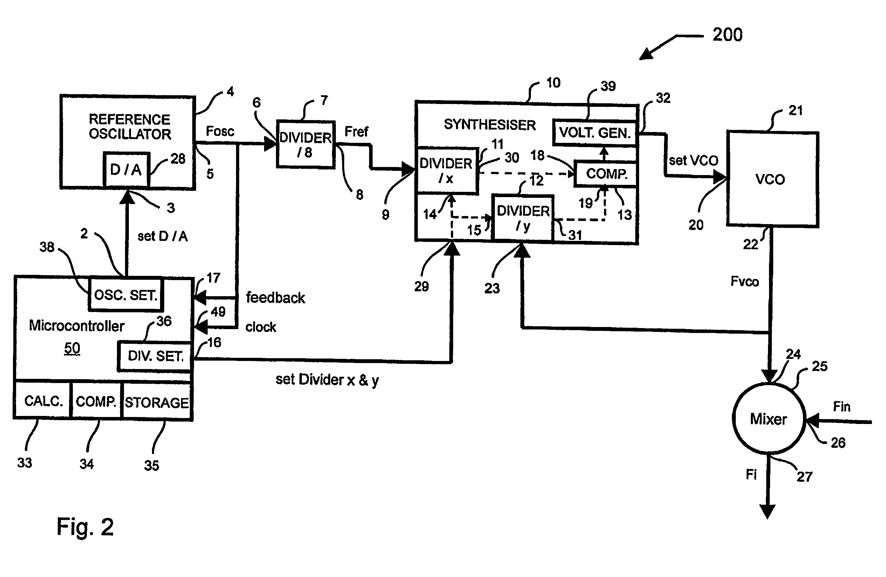

The synthesiser arrangement 200 shown in Fig. 2 is distinguished from the synthesiser arrangement 100 in Fig. 1 by a microcontroller 50 (instead of microcontroller 1) comprising calculating means 33, a comparator 34, and a storage 35.

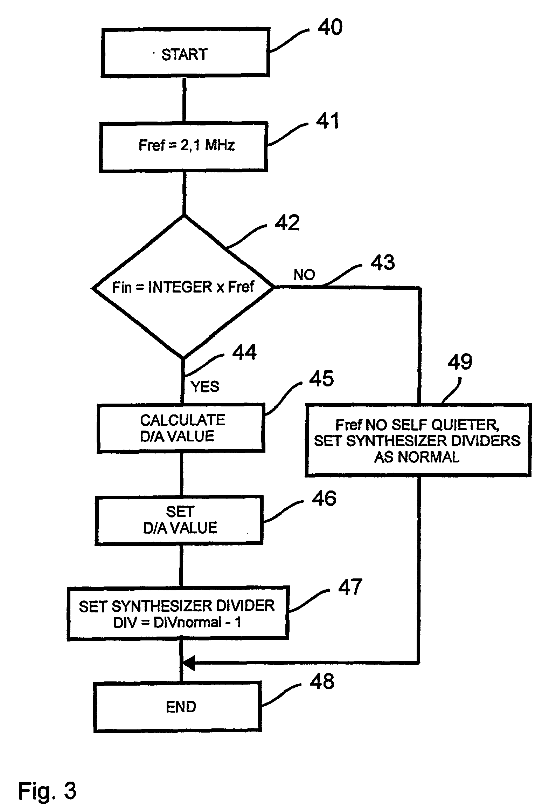

In an initial state, the adjusted incoming frequency of the radio frequency receiver is said to be different from an integral multiple of the divided frequency generated by the oscillator 4 (40 in Fig. 3). Such incoming frequency is said to be 167 MHz, for example. The oscillator 4 is set by the microcontroller 50 to generate an oscillator frequency $F_{osc}$ of 16.8 MHz (like microcontroller 1 in the synthesiser arrangement 100 of the prior art), which is divided by means of divider 7 by the divisor 8 and a reference frequency $F_{ref}$ of 2.1 MHz (41 in Fig. 3) is obtained at the output 8 of divider 7, which is applied to input 9 of divider 11 of the synthesiser 10.

If the radio frequency receiver is now adjusted to demodulate a modulated radio wave with another incoming frequency, such as 168 MHz, for example, a harmonic wave of the reference frequency $F_{ref}$ of 2.1 MHz, namely the harmonic wave with 80 * 2.1 MHz = 168 MHz may disturb a weak incoming signal to be demodulated by the radio frequency receiver. As mentioned, a harmonic wave with a frequency value, which is the same as the adjusted incoming frequency of the radio frequency receiver and which disturbs a received signal, is called a "self quieter" (49 in Fig. 3).

In order to allow that any incoming frequency, within the frequency range of the radio frequency receiver, may be demodulated, a comparator 34 in microcontroller 50 compares, whether the new adjusted incoming frequency is an integral multiple of the reference frequency $F_{ref}$, which is "normally" 2.1 MHz (41 in Fig. 3). Since the new adjusted incoming frequency of 168 MHz is an integral multiple of the "normal" reference frequency $F_{ref}$ of 2.1 MHz, the reference frequency $F_{ref}$ needs to be shifted to another reference frequency $F_{ref2}$, which is not an integral multiple of the incoming frequency to be demodulated. A stored or calculated digital value is used to set the digital/analog converter 28 by the oscillator setting means 38. Accordingly, the reference oscillator 4 generates another oscillator frequency $F_{osc2}$ and the "normal" reference frequency $F_{ref}$ is shifted to $F_{ref2}$.

Since this would cause that the VCO 21 also generates another output frequency $F_{VCO2}$ and that an intermediate frequency for the demodulation of another incoming frequency $F_{in2}$ would be generated by mixer 25, the divider settings of the dividers 11 and 12 of synthesiser 10 have to be adapted with regard to the shifted reference frequency. This is necessary, in order to assure that voltage controlled oscillator 21 still generates the same output frequency as before shifting the reference frequency.

The reference frequency shift from the first oscillator frequency to a second oscillator frequency to avoid a "self quieter" and the corresponding adjustment of the divider settings of divider 11 and divider 12 of the synthesiser 10 according to the invention may be described by the equation:

$$F_{ref2} * ((y-1)/x)) = F_{ref} * (y/x) \qquad (1)$$

which describes the preferred adjustment or compensation, whereby the new reference frequency comprises a 1 channel offset with regard to the "normal" reference frequency and the divisor y of the divider 12, by which the output frequency $F_{VCO}$ of the voltage controlled oscillator VCO is divided, has been decremented by the number 1 and divisor x of divider 11 has been kept constant (47 in Fig. 3). For x = 84, y = 8514 and Fref = 2.1 MHz, the new reference frequency $F_{ref2}$ is 2.100247 MHz and the reference oscillator 4 needs to generate a signal with a new oscillator frequency of 16.801973 MHz. To achieve that, the D/A 28 has to be set by an appropriate digital value.

It will be understood that it is also possible to increment the divisor y, by which the output frequency of the voltage controlled oscillator 21 is divided by divider 12, which may be described by the equation:

$$F_{ref2} * ((y+1)/x)) = F_{ref} * (y/x) \qquad (2)$$

Since the oscillator frequency of reference oscillator 4 can currently only be shifted in a typical range of up to about 100 kHz, it will be understood that the frequency shift is limited to a small range and accordingly the settings of the dividers 11 and 12 are changed only slightly, for example by 1 - as mentioned - or another low number, such as 2, 3 or 4. Since the 1 channel offset appears to be sufficient to avoid "self quieters", such single channel offset preferred. An offset of only 1 channel (or a low number of channel offsets) has the advantage that the oscillator frequency of reference oscillator 4 has to be changed only slightly. This allows that the oscillator frequency of reference oscillator 4 is still very stable and precise, although the oscillator frequency has been shifted to avoid the "self quieter".

After the described shifting of the reference frequency of reference oscillator 4 and corresponding adjustment of the settings of dividers 11 and 12 a signal on a carrier wave of 168 MHz is demodulated (48 in Fig. 3)

If a new incoming frequency $F_{in2}$ has been adjusted, which is not an integral multiple of the reference frequency $F_{ref}$ with 2.1 MHz, the reference frequency is not shifted (43 in Fig. 3), since the reference frequency $F_{ref}$ is no self quieter and the dividers 11 and 12 of synthesiser 10 are set "normally" (49 in Fig. 3).

However, every 2.1 MHz, in this example starting from 168 MHz, the "normal" reference frequency $F_{ref}$ = 2.1 MHz is a self quieter, i.e. for incoming frequencies of ... 165.9 MHz, 168 MHz, 170.1 MHz, ... and so on.

Accordingly, for each such incoming frequency the "normal" x and y settings as well as the digital value for triggering the reference oscillator 4 (by oscillator setting means 38 and D/A 28) to generate an oscillator frequency $F_{osc2}$ (x, y) and reference frequency $F_{ref2}$ (x, y), which is appropriate (see equations (1) and (2)) needs to be known.

To obtain the appropriate digital value to trigger the reference oscillator 4 to generate the shifted oscillator frequency $F_{osc2}$ of 16.801973 MHz to avoid a "self quieter", when the receiver is tuned to receive at 168 MHz, the divider setting means 36 set the dividers 11 and 12 with x = 84 and y - 1 = 8514 - 1 = 8513.

After doing so, the output frequency $F_{VCO}$ at output 22 of VCO 21, which is 212.85 MHz for "normal" $F_{osc}$ = 16.8 MHz, is measured. Since the divisor y has been decremented the output frequency of the VCO 21 will be too low for x = 84 and y = 8513, i.e. the output frequency is lower than 212.85 MHz as needed.

Now the digital value to set the D/A 28 of reference oscillator 4 is stepwise increased until the output frequency of the VCO 21 is 212.85 MHz. This appropriate digital value for the incoming frequency of 168 MHz is stored in a storage 35 of the microprocessor 50, which is preferably an EEPROM.

The same method is then used for determining the appropriate digital values for other incoming frequencies for which "normal" $F_{osc}$ = 16.8 MHz or $F_{ref}$ = 2.1 MHz is a "self quieter".

In order to minimise the effort for determining all appropriate digital values for all such incoming frequencies within the frequency range of the specific receiver, preferably only appropriate digital values for about 3 or 4 such incoming frequencies are determined and stored in storage 35.

If now such an incoming frequency is adjusted at the receiver for which the appropriate digital value has not been determined, the microcontroller 50, which preferably comprises a microprocessor, interpolates the appropriate digital value by using the determined appropriate digital values for other such incoming frequencies, which are stored in storage 35 of microcontroller 50.

Reference list:

| | |
|---|---|
| 1 | microcontroller |
| 2 | output of microcontroller |
| 3 | input of digital/analog converter |
| 4 | reference oscillator |
| 5 | output of reference oscillator |
| 6 | input of divider |
| 7 | divider |
| 8 | output of divider |
| 9 | input of divider |
| 10 | synthesiser |
| 11 | divider |
| 12 | divider |
| 13 | comparator |
| 14 | input |
| 15 | input |
| 16 | output |
| 17 | input |
| 18 | input |
| 19 | input |
| 20 | input |
| 21 | voltage controlled oscillator |
| 22 | output |
| 23 | input |
| 24 | input |
| 25 | mixer |
| 26 | input |
| 27 | output |
| 28 | digital/analog converter |
| 29 | input |
| 30 | output |
| 31 | output |
| 32 | output |
| 33 | calculation means |
| 34 | comparator |
| 35 | storage |
| 36 | divider setting means |
| 38 | oscillator setting means |
| 39 | voltage generator |
| 40 | start of setting dividers |
| 41 | generation of the "normal" reference frequency |
| 42 | check for integral multiple |
| 43 | result |
| 44 | result |
| 45 | calculation of D/A value |
| 46 | setting of D/A value |
| 47 | setting of synthesiser dividers |
| 48 | end of setting dividers |
| 50 | microcontroller |
| 100 | known synthesiser arrangement |
| 200 | synthesiser arrangement |

**Claims**

1. A radio frequency signal receiver being adjusted to demodulate a modulated radio wave with a first incoming frequency ($F_{in}$) comprising a synthesiser arrangement (100; 200), the synthesiser arrangement including:

   - a first oscillator (4) generating a first frequency ($F_{ref}$) ;
   - a synthesiser (10) comprising:

      - a first divider (11) dividing said first frequency ($F_{ref}$) by a first divisor (x);
      - a second divider (12) dividing the output frequency ($F_{VCO}$) of a voltage controlled oscillator (VCO) (21) by a second divisor (y);
      - a first comparator (13) comparing said divided first frequency ($F_{ref}$) with said divided output frequency ($F_{VCO}$) ; and
      - a voltage generator (39) triggered by said comparator (13) generating a voltage being dependent on said first and second divisors (x, y) and being applied to said voltage controlled oscillator (21), so that said divided first frequency ($F_{ref}$, $F_{ref2}$) matches said divided output frequency ($F_{VCO}$) ;

   - a mixer (25) to which said output frequency ($F_{VCO}$) and said modulated radio wave is applied and which outputs an intermediate frequency ($F_i$) to be demodulated by said receiver; and

- a controller (1) comprising:

    - divider setting means (36) setting said first divisor (x) and said second divisor (y) and
    - oscillator setting means (38) setting said first oscillator (4) by a digital/analog converter (28),

**characterised by**

- a second comparator (34) comparing, whether said adjusted first incoming frequency ($F_{in}$) is an integral multiple of said first frequency ($F_{osc}$, $F_{ref}$) ;

and if so, said controller (1) triggering:

- said oscillator setting means (38) to set said first oscillator (4) to generate a second frequency ($F_{osc2}$, $F_{ref2}$), whereby said adjusted first incoming frequency ($F_{in}$) is different from an integral multiple of said second frequency ($F_{osc2}$, $F_{ref2}$) ; and
- said divider setting means (36) change at least one of said first and second divisors (x, y) to compensate the frequency shift from said first to said second frequency.

2. Receiver of claim 1, **characterised in that** said divider setting means (36) decrement said second divisor (y) by 1 and said oscillator setting means (38) setting said first oscillator (4) to generate a second frequency ($F_{osc2}$, $F_{ref2}$), whereby

$$F_{ref2} * ((y-1)/x)) = F_{ref} * (y/x).$$

3. Receiver of claim 1, **characterised in that** said divider setting means (36) increment said second divisor (y) by 1 and said oscillator setting means (38) setting said first oscillator (4) to generate a second frequency ($F_{osc2}$, $F_{ref2}$), whereby

$$F_{ref2} * ((y+1)/x)) = F_{ref} * (y/x).$$

4. Receiver of claim 1, **characterised in that** said divider setting means (36) keep said output frequency ($F_{VCO}$) constant, when shifting said first to said second frequency ($F_{osc}$, $F_{ref}$; $F_{osc2}$, $F_{ref2}$).

5. Receiver of claim 1, **characterised in that** said frequency shift is a 1 channel offset.

6. Receiver of claim 1 or 5, **characterised in that** said frequency shift is about 25 kHz.

7. Receiver of claim 1, **characterised in that** said receiver is a VHF receiver for the demodulation of radio waves with a carrier frequency in the range of about 130 - 180 MHz.

8. Receiver of claim 1, **characterised in that** said first frequency ($F_{osc}$) is applied to said controller (1) to clock said controller.

9. Receiver of claim 1 or 8, **characterised in that** said second frequency ($F_{osc2}$) is applied to said controller (1) to clock said controller.

10. Receiver of claim 1, **characterised by** a storage (35) storing first data corresponding to at least said first incoming frequency ($F_{in}$) being an integral multiple of said first frequency ($F_{osc}$, $F_{ref}$) and at least one set of second data corresponding to said second frequency ($F_{osc2}$, $F_{ref2}$) and said change (x, y-1; x, y+1) of said at least one of said first and second divisors (x, y).

11. Receiver of claim 10, **characterised by** calculating means (33) calculating data applied to said oscillator setting means (38) and said data calculation being an interpolation on the basis of at least two sets of said second data.

12. A method of controlled frequency shift ($F_{osc2}$, $F_{ref2}$) of a first frequency ($F_{osc}$, $F_{ref}$) generated by a first oscillator (4) in a radio frequency receiver with an adjusted first incoming frequency ($F_{in}$) comprising the steps of:

    - comparing, whether said first incoming frequency ($F_{in}$) is an integral multiple of said first frequency ($F_{osc}$, $F_{ref}$) ; and
    - if so:

        - setting said first oscillator (4) to generate a second frequency ($F_{osc2}$, $F_{ref2}$), wherein said adjusted first incoming frequency ($F_{in}$) is different from an integral multiple of said second frequency ($F_{osc2}$, $F_{ref2}$) ; and
        - setting divider setting means (36) of a synthesiser (10), the synthesiser comprising:

            - a first divider (11) dividing said first frequency ($F_{ref}$) by a first divisor (x);
            - a second divider (12) dividing the output frequency ($F_{VCO}$) of a voltage controlled oscillator (VCO) (21) by a second divisor (y);
            - a first comparator (13) comparing said divided first frequency ($F_{ref}$) with said divided output frequency ($F_{VCO}$); and
            - a voltage generator (39) triggered by said comparator (13) generating a voltage being dependent on said first and second divisors (x, y) and being applied to said voltage controlled oscillator (21), so that said divided first frequency ($F_{ref}$) matches said divided output frequency ($F_{VCO}$) ;

- to change at least one of said first and second divisors (x, y) to compensate the frequency shift from said first to said second frequency ($F_{osc}$, $F_{ref}$; $F_{osc2}$, $F_{ref2}$).

**13.** Method of claim 12, **characterised in that** said divider setting means (36) decrement said second divisor by 1 and said oscillator setting means (38) setting said first oscillator (4) to generate a second frequency ($F_{osc2}$, $F_{ref2}$), whereby

$$F_{ref2} * ((y\text{-}1)/x)) = F_{ref} * (y/x).$$

**14.** Method of claim 12, **characterised in that** said divider setting means (36) increment said second divisor by 1 and said oscillator setting means (38) setting said first oscillator (4) to generate a second frequency ($F_{osc2}$, $F_{ref2}$), whereby

$$F_{ref2} * ((y\text{+}1)/x)) = F_{ref} * (y/x).$$

**15.** Method of claim 12, **characterised in that** said first frequency ($F_{osc}$) is applied to said controller (1) to clock said controller.

**16.** Method of claim 12 or 15, **characterised in that** said second frequency ($F_{osc2}$) is supplied to said controller (1) to clock said controller.


**Patentansprüche**

**1.** Radiofrequenz-Signalempfänger, eingerichtet zum Demodulieren einer modulierten Funkwelle mit einer ersten Eingangsfrequenz ($F_{in}$), umfassend eine Synthesizeranordnung (100; 200), wobei die Synthesizeranordnung enthält:

- einen ersten Oszillator (4) der eine erste Frequenz ($F_{ref}$) erzeugt;
- einen Synthesizer (10), umfassend:

   - einen ersten Teiler (11), der die erste Frequenz ($F_{ref}$) durch einen ersten Divisor (x) teilt,
   - einen zweiten Teiler (12), der die Ausgangsfrequenz ($F_{VCO}$) eines spannungsgesteuerten Oszillators (VCO) (21) durch einen zweiten Divisor (y) teilt,

   - einen ersten Komparator (13), der die geteilte erste Frequenz ($F_{ref}$) mit der geteilten Ausgangsfrequenz ($F_{VCO}$) vergleicht, und
   - einen von dem Komparator (13) getriggerten Spannungserzeuger (39), der eine Spannung erzeugt, die von dem ersten und dem zweiten Divisor (x, y) abhängt und an den spannungsgesteuerten Oszillator (21) angelegt wird, so dass die geteilte erste Frequenz ($F_{ref}$, $F_{ref2}$) mit der geteilten Ausgangsfrequenz ($F_{VCO}$) übereinstimmt,

- einen Mischer (25), an den die Ausgangsfrequenz ($F_{VCO}$) und die modulierter Funkwelle angelegt wird und der eine Zwischenfrequenz ($F_i$) zur Demodulation durch den Empfänger ausgibt, und
- eine Steuereinheit (1), umfassend:

   - Teiler-Einstellmittel (36), die den ersten Divisor (x) und den zweiten Divisor (y) einstellen und
   - Oszillator-Einstellmittel (38), die den ersten Oszillator (4) durch einen Digital/Analog-Wandler (28) einstellen,

**gekennzeichnet durch**

- einen zweiten Komparator (34), der vergleicht, ob die eingestellte, erste Eingangsfrequenz ($F_{in}$) ein ganzzahliges Vielfaches der ersten Frequenz ($F_{osc}$, $F_{ref}$) ist, und,

wenn dies der Fall ist, triggert die Steuereinheit (1):

- die Oszillator-Einstellmittel (38), um den ersten Oszillator (4) so einzustellen, dass er eine zweite Frequenz ($F_{osc2}$, $F_{ref2}$) erzeugt, wodurch die eingestellte, erste Eingangsfrequenz ($F_{in}$) verschieden ist von einem ganzzahligen Vielfachen der zweiten Frequenz ($F_{osc2}$, $F_{ref2}$), und
- die Teiler-Einstellmittel, um (36) zumindest einen des ersten und des zweiten Divisors (x, y) zu ändern, um die Frequenzverschiebung von der ersten zu der zweiten Frequenz zu kompensieren.

**2.** Empfänger nach Anspruch 1, **dadurch gekennzeichnet, dass** die Teiler-Einstellmittel (36) den zweiten Divisor (y) um eins verringern und die Oszillator-Einstellmittel (38) den ersten Oszillator (4) so einstellen, dass er eine zweite Frequenz ($F_{osc2}$, $F_{ref2}$) erzeugt, wobei

$$F_{ref2}*((y\text{-}1)/x)=F_{ref}*(y/x).$$

**3.** Empfänger nach Anspruch 1, **dadurch gekennzeichnet, dass** die Teiler-Einstellmittel (36) den zweiten Divisor (y) um eins erhöhen und die Oszillator-Einstellmittel (38) den ersten Oszillator (4) so einstellen, dass er eine zweite Frequenz ($F_{osc2}$, $F_{ref2}$) erzeugt, wobei

$$F_{ref2}*((y+1)/x)=F_{ref}*(y/x).$$

**4.** Empfänger nach Anspruch 1, **dadurch gekennzeichnet, dass** die Teiler-Einstellmittel (36) bei der Verschiebung der ersten Frequenz zu der zweiten Frequenz ($F_{osc}$, $F_{ref}$; $F_{osc2}$, $F_{ref2}$) die Ausgangsfrequenz ($F_{VOC}$) konstant halten.

**5.** Empfänger nach Anspruch 1, **dadurch gekennzeichnet, dass** die Frequenzverschiebung ein Versatz um einen Kanal ist.

**6.** Empfänger nach Anspruch 1 oder 5, **dadurch gekennzeichnet, dass** die Frequenzverschiebung in etwa 25 kHz beträgt.

**7.** Empfänger nach Anspruch 1, **dadurch gekennzeichnet, dass** der Empfänger ein VHF-Empfänger zur Demodulation von Funkwellen mit einer Trägerfrequenz im Bereich von 130 - 180 MHz ist.

**8.** Empfänger nach Anspruch 1, **dadurch gekennzeichnet, dass** die erste Frequenz ($F_{osc}$) an die Steuereinheit (1) angelegt wird, um diese zu takten.

**9.** Empfänger nach Anspruch 1 oder 8, **dadurch gekennzeichnet, dass** die zweite Frequenz ($F_{osc2}$) an die Steuereinheit (1) angelegt wird, um diese zu takten.

**10.** Empfänger nach Anspruch 1, **gekennzeichnet durch** einen Speicher (35) zum Speichern erster Daten, die wenigstens der ersten Eingangsfrequenz ($F_{in}$) entsprechen, welche ein ganzzahliges Vielfaches der ersten Frequenz ($F_{osc}$, $F_{ref}$) ist, und wenigstens eines Satzes zweiter Daten, die der zweiten Frequenz ($F_{osc2}$, $F_{ref2}$) entsprechen, sowie der Änderung (x, y-1; x, y+1) des zumindest einen des ersten und des zweiten Divisors (x, y).

**11.** Empfänger nach Anspruch 10, **gekennzeichnet durch** Berechnungsmittel (33) zur Berechnung von an den Oszillator-Einstellmitteln (38) angelegten Daten, wobei diese Datenberechnung eine Interpolation auf Grundlage wenigstens zweier Sätze der zweiten Daten ist.

**12.** Verfahren zur gesteuerten Frequenzverschiebung ($F_{osc2}$, $F_{ref2}$) einer ersten Frequenz ($F_{osc}$, $F_{ref}$), erzeugt von einem ersten Oszillator (4) in einem Radiofrequenz-Empfänger mit einer eingestellten ersten Eingangsfrequenz ($F_{in}$), umfassend die Schritte:

- Vergleichen, ob die erste Eingangsfrequenz ($F_{in}$) ein ganzzahliges Vielfaches der ersten Frequenz ($F_{osc}$, $F_{ref}$) ist und,
- falls dies der Fall ist,
- Einstellen des ersten Oszillators (4) zum Erzeugen einer zweiten Frequenz ($F_{osc2}$, $F_{ref2}$), wobei die eingestellte erste Eingangsfrequenz ($F_{in}$) verschieden ist von einem ganzzahligen Vielfachen der zweiten Frequenz ($F_{osc2}$, $F_{ref2}$), und
- Einstellen von Teiler-Einstellmitteln (36) eines Synthesizers (10), wobei der Synthesizer umfasst:

  - einen ersten Teiler (11), der die erste Frequenz ($F_{ref}$) durch einen ersten Divisor (x) teilt,
  - einen zweiten Teiler (12), der die Ausgangsfrequenz ($F_{VCO}$) eines spannungsgesteuerten Oszillators (VCO) (21) durch einen zweiten Divisor (y) teilt,
  - einen ersten Komparator (13), der die geteilte erste Frequenz ($F_{ref}$) mit der geteilten Ausgangsfrequenz ($F_{VCO}$) vergleicht, und
  - einen von dem Komparator (13) getriggerten Spannungserzeuger (39), der eine Spannung erzeugt, die von dem ersten und dem zweiten Divisor (x, y) abhängt und an den spannungsgesteuerten Oszillator (21) angelegt wird, so dass die geteilte erste Frequenz ($F_{ref}$) mit der geteilten Ausgangsfrequenz ($F_{VCO}$) übereinstimmt,

- um zumindest einen des ersten und des zweiten Divisors (x, y) so zu ändern, dass die Frequenzverschiebung von der ersten zu der zweiten Frequenz ($F_{osc}$, $F_{ref}$; $F_{osc2}$, $F_{ref2}$) kompensiert wird.

**13.** Verfahren nach Anspruch 12, **dadurch gekennzeichnet, dass** die Teiler-Einstellmittel (36) den zweiten Divisor um eins verringern und die Oszillator-Einstellmittel (38) den ersten Oszillator (4) so einstellen, dass er eine zweite Frequenz ($F_{osc2}$, $F_{ref2}$) erzeugt, wobei

$$F_{ref2}*((y-1)/x)=F_{ref}*(y/x).$$

**14.** Verfahren nach Anspruch 12, **dadurch gekennzeichnet, dass** die Teiler-Einstellmittel (36) den zweiten Divisor um eins erhöhen und die Oszillator-Einstellmittel (38) den ersten Oszillator (4) so einstellen, dass er eine zweite Frequenz ($F_{osc2}$, $F_{ref2}$)

erzeugt, wobei

$$F_{ref2} * ((y+1)/x) = F_{ref} * (y/x).$$

15. Verfahren nach Anspruch 12, **dadurch gekennzeichnet, dass** die erste Frequenz ($F_{osc}$) an die Steuereinheit (1) angelegt wird, um diese zu takten.

16. Verfahren nach Anspruch 12 oder 15, **dadurch gekennzeichnet, dass** die zweite Frequenz ($F_{osc2}$) der Steuereinheit (1) zugeführt wird, um diese zu takten.

**Revendications**

1. Récepteur de signal radio fréquence qui est réglé pour démoduler une onde radio modulée avec une première fréquence arrivante ($F_{in}$) comprenant un agencement de synthétiseur (100 ; 200), l'agencement de synthétiseur incluant :

   un premier oscillateur (4) qui génère une première fréquence ($F_{ref}$);
   un synthétiseur (10) comprenant :

   un premier moyen de division (11) qui divise ladite première fréquence ($F_{ref}$) par un premier diviseur (x) ;
   un second moyen de division (12) qui divise la fréquence de sortie ($F_{VCO}$) d'un oscillateur commandé en tension (VCO) (21) par un second diviseur (y) ;
   un premier comparateur (13) qui compare ladite première fréquence divisée ($F_{ref}$) à ladite fréquence de sortie divisée ($F_{VCO}$) ; et
   un générateur de tension (39) qui est déclenché par ledit comparateur (13) en générant une tension qui dépend desdits premier et second diviseurs (x, y) et qui est appliquée sur ledit oscillateur commandé en tension (21) de telle sorte que ladite première fréquence divisée ($F_{ref}$, $F_{ref2}$) corresponde à ladite fréquence de sortie divisée ($F_{VCO}$) ;

   un mélangeur (25) sur lequel ladite fréquence de sortie ($F_{VCO}$) et ladite onde radio modulée sont appliquées et qui émet en sortie une fréquence intermédiaire ($F_i$) destinée à être démodulée par ledit récepteur ; et
   un contrôleur (1) comprenant :

   un moyen d'établissement de diviseur (36) qui établit ledit premier diviseur (x) et ledit second diviseur (y) ; et

   un moyen d'établissement d'oscillateur (38) qui établit ledit premier oscillateur (4) au moyen d'un convertisseur numérique-analogique ou N/A (28),

   **caractérisé par** :

   un second comparateur (34) qui réalise une comparaison pour déterminer si oui ou non ladite première fréquence arrivante réglée ($F_{in}$) est un multiple entier de ladite première fréquence ($F_{osc}$, $F_{ref}$);

   et s'il en est ainsi, ledit contrôleur (1) déclenchant :

   ledit moyen d'établissement d'oscillateur (38) pour établir ledit premier oscillateur (4) afin de générer une seconde fréquence ($F_{osc2}$, $F_{ref2}$), et ainsi, ladite première fréquence arrivante réglée ($F_{in}$) est différente d'un multiple entier de ladite seconde fréquence ($F_{osc2}$, $F_{ref2}$); et
   ledit moyen d'établissement de diviseur (36) modifie au moins l'un desdits premier et second diviseurs (x, y) de manière à compenser le décalage de fréquence depuis ladite première fréquence jusqu'à ladite seconde fréquence.

2. Récepteur selon la revendication 1, **caractérisé en ce que** ledit moyen d'établissement de diviseur (36) décrémente ledit second diviseur (y) d'une unité et ledit moyen d'établissement d'oscillateur (38) établit ledit premier oscillateur (4) de manière à générer une seconde fréquence ($F_{osc2}$, $F_{ref2}$) et ainsi :

$$F_{ref2} * ((y - 1)/x) = F_{ref} * (y/x).$$

3. Récepteur selon la revendication 1, **caractérisé en ce que** ledit moyen d'établissement de diviseur (36) incrémente ledit second diviseur (y) d'une unité et ledit moyen d'établissement d'oscillateur (38) établit ledit premier oscillateur (4) de manière à générer une seconde fréquence ($F_{osc2}$, $F_{ref2}$) et ainsi :

$$F_{ref2} * ((y + 1)/x) = F_{ref} * (y/x).$$

4. Récepteur selon la revendication 1, **caractérisé en ce que** ledit moyen d'établissement de diviseur (36) maintient ladite fréquence de sortie ($F_{VCO}$) constante lors du décalage de ladite première fréquence sur ladite seconde fréquence ($F_{osc}$, $F_{ref}$ ; $F_{osc2}$, $F_{ref2}$).

5. Récepteur selon la revendication 1, **caractérisé en ce que** ledit décalage de fréquence est un décalage d'un canal.

6. Récepteur selon la revendication 1 ou 5, **caractérisé en ce que** ledit décalage de fréquence est d'environ 25 kHz.

7. Récepteur selon la revendication 1, **caractérisé en ce que** ledit récepteur est un récepteur VHF pour la démodulation d'ondes radio présentant une fréquence de porteuse dans la plage qui va d'environ 130 MHz à environ 180 MHz.

8. Récepteur selon la revendication 1, **caractérisé en ce que** ladite première fréquence ($F_{osc}$) est appliquée sur ledit contrôleur (1) afin de cadencer ledit contrôleur.

9. Récepteur selon la revendication 1 ou 8, **caractérisé en ce que** ladite seconde fréquence ($F_{osc2}$) est appliquée sur ledit contrôleur (1) afin de cadencer ledit contrôleur.

10. Récepteur selon la revendication 1, **caractérisé par** un moyen de stockage (35) qui stocke des premières données en correspondance avec au moins ladite première fréquence arrivante ($F_{in}$) qui est un multiple entier de ladite première fréquence ($F_{osc}$, $F_{ref}$) et au moins un jeu de secondes données en correspondance avec ladite seconde fréquence ($F_{osc2}$, $F_{ref2}$) et ladite variation (x, y - 1 ; x, y + 1) dudit au moins un desdits premier et second diviseurs (x, y).

11. Récepteur selon la revendication 10, **caractérisé par** un moyen de calcul (33) qui calcule des données qui sont appliquées sur ledit moyen d'établissement d'oscillateur (38), ledit calcul de données étant une interpolation qui est basée sur au moins deux jeux desdites secondes données.

12. Procédé de décalage de fréquence commandé ($F_{osc2}$, $F_{ref2}$) d'une première fréquence ($F_{osc}$, $F_{ref}$) qui est générée par un premier oscillateur (4) dans un récepteur de fréquence radio avec une première fréquence arrivante réglée ($F_{in}$), comprenant les étapes de :

comparaison pour déterminer si oui ou non ladite première fréquence arrivante ($F_{in}$) est un multiple entier de ladite première fréquence ($F_{osc}$, $F_{ref}$); et
s'il en est ainsi :

établissement dudit premier oscillateur (4) afin de générer une seconde fréquence ($F_{osc2}$, $F_{ref2}$), où ladite première fréquence arrivante réglée ($F_{in}$) est différente d'un multiple entier de ladite seconde fréquence

($F_{osc2}$, $F_{ref2}$); et
établissement d'un moyen d'établissement de diviseur (36) et d'un synthétiseur (10), le synthétiseur comprenant :

un premier moyen de division (11) qui divise ladite première fréquence ($F_{ref}$) par un premier diviseur (x) ;
un second moyen de division (12) qui divise la fréquence de sortie ($F_{VCO}$) d'un oscillateur commandé en tension (VCO) (21) par un second diviseur (y) ;
un premier comparateur (13) qui compare ladite première fréquence divisée ($F_{ref}$) avec ladite fréquence de sortie divisée ($F_{VCO}$) ; et
un générateur de tension (39) qui est déclenché par ledit comparateur (13) en générant une tension qui dépend desdits premier et second diviseurs (x, y) et qui est appliquée sur ledit oscillateur commandé en tension (21) de telle sorte que ladite première fréquence divisée ($F_{ref}$) corresponde à ladite fréquence de sortie divisée ($F_{VCO}$) ;

modification d'au moins l'un desdits premier et second diviseurs (x, y) afin de compenser le décalage de fréquence depuis ladite première fréquence jusqu'à ladite seconde fréquence ($F_{osc}$, $F_{ref}$ ; $F_{osc2}$, $F_{ref2}$).

13. Procédé selon la revendication 12, **caractérisé en ce que** ledit moyen d'établissement de diviseur (36) décrémente ledit second diviseur d'une unité et ledit moyen d'établissement d'oscillateur (38) établit ledit premier oscillateur (4) de manière à générer une seconde fréquence ($F_{osc2}$, $F_{ref2}$) et ainsi :

$$F_{ref2} * ((y - 1)/x) = F_{ref} * (y/x).$$

14. Procédé selon la revendication 12, **caractérisé en ce que** ledit moyen d'établissement de diviseur (36) décrémente ledit second diviseur d'une unité et ledit moyen d'établissement d'oscillateur (38) établit ledit premier oscillateur (4) de manière à générer une seconde fréquence ($F_{osc2}$, $F_{ref2}$) et ainsi :

$$F_{ref2} * ((y + 1)/x) = F_{ref} * (y/x).$$

15. Procédé selon la revendication 12, **caractérisé en ce que** ladite première fréquence ($F_{osc}$) est appliquée sur ledit contrôleur (1) de manière à cadencer ledit contrôleur.

16. Procédé selon la revendication 12 ou 15, **caracté-**

**risé en ce que** ladite seconde fréquence ($F_{osc2}$) est appliquée sur ledit contrôleur (1) de manière à cadencer ledit contrôleur.

Fig. 1   ( PRIOR ART )

Fig. 2

Fig. 3